(19) 

Europäisches
Patentamt
European
Patent Office
Office européen
des brevets

(11) **EP 4 495 617 A1**

(12) **EUROPEAN PATENT APPLICATION**
published in accordance with Art. 153(4) EPC

(43) Date of publication:
**22.01.2025 Bulletin 2025/04**

(21) Application number: **23770548.8**

(22) Date of filing: **07.03.2023**

(51) International Patent Classification (IPC):
*G01R 31/392* (2019.01)    *H01M 10/42* (2006.01)
*H01M 10/48* (2006.01)

(52) Cooperative Patent Classification (CPC):
**G01R 31/392; H01M 10/42; H01M 10/48;**
**Y02E 60/10**

(86) International application number:
**PCT/JP2023/008593**

(87) International publication number:
**WO 2023/176592 (21.09.2023 Gazette 2023/38)**

(84) Designated Contracting States:
**AL AT BE BG CH CY CZ DE DK EE ES FI FR GB**
**GR HR HU IE IS IT LI LT LU LV MC ME MK MT NL**
**NO PL PT RO RS SE SI SK SM TR**
Designated Extension States:
**BA**
Designated Validation States:
**KH MA MD TN**

(30) Priority: **18.03.2022  JP 2022043907**

(71) Applicants:
• **Osaka Gas Co., Ltd.**
  **Osaka-shi, Osaka 541-0046 (JP)**

• **KRI, Inc.**
  **Kyoto-shi, Kyoto 600-8813 (JP)**

(72) Inventors:
• **MIZOGUCHI Yasunori**
  **Kyoto-shi, Kyoto 600-8813 (JP)**
• **HAYANO Akihito**
  **Kyoto-shi, Kyoto 600-8813 (JP)**
• **KINOSHITA Hajime**
  **Kyoto-shi, Kyoto 600-8813 (JP)**

(74) Representative: **LBP Lemcke, Brommer & Partner**
  **Patentanwälte mbB**
  **Siegfried-Kühn-Straße 4**
  **76135 Karlsruhe (DE)**

(54) **DEGRADATION STATE PREDICTION METHOD, DEGRADATION STATE PREDICTION DEVICE, AND DEGRADATION STATE PREDICTION PROGRAM**

(57)     It is aimed to accurately predict a deterioration state of a secondary battery. A deterioration-state prediction method is for calculating a cause-based deterioration state 25 for each cause of deterioration and predicting a deterioration state 26 of a secondary battery 1 based on a plurality of the cause-based deterioration states 25. Each of the cause-based deterioration states 25 is calculated based on: a previous cause-based deterioration state 21, which is the cause-based deterioration state 25 at a time point a first time period ago; and a unit cause-based deterioration state indicating deterioration during the first time period, while considering: time dependence varying depending on the cause of deterioration and following a power law with respect to an elapsed time of the cause-based deterioration state 25; and a deterioration rate varying depending on the cause of deterioration and determined based on a use condition 22 at the time of prediction.

Fig.1

## Description

Technical Field

The present invention relates to a deterioration-state prediction method, a deterioration-state prediction apparatus, and a deterioration-state prediction program for predicting the deterioration state of a chargeable and dischargeable secondary battery.

Background Art

A secondary battery can supply stored electric power to various devices by discharging electric power stored by charging. Deterioration of the secondary battery, such as a decrease in full charge capacity, progresses due to repeated charging and discharging and long-term storage. The deterioration state of the secondary battery may be predicted for healthy and continuous use of the secondary battery.

Patent Document 1 discloses, for example, a method of calculating the deterioration state of a secondary battery based on the power law of time with a deterioration rate as a coefficient.

Prior Art Documents

Patent Documents

Patent Document 1: WO 2019/171688

Disclosure of the Invention

Problem to be Solved by the Invention

However, the progress of deterioration greatly changes depending on use conditions, and the use conditions change from time to time while the secondary battery is used. Particularly when one power storage device is shared by a plurality of applications, e.g. when an electric vehicle is connected to a power grid and also used for leveling, the charging and discharging methods and conditions greatly differ between charging and discharging of the electric vehicle and charging and discharging for power leveling. This makes it difficult to accurately predict the deterioration state.

An object of the present invention is to accurately predict the deterioration state of the secondary battery.

Means for Solving Problem

To achieve the above-stated object, a characteristic configuration of a deterioration-state prediction method according to one embodiment of the present invention lies in a deterioration-state prediction method for calculating a cause-based deterioration state for each cause of deterioration and predicting a deterioration state of a secondary battery based on a plurality of the cause-based deterioration states, the method including: calculating each of the cause-based deterioration states based on: a previous cause-based deterioration state being the cause-based deterioration state a first time period ago; and a unit cause-based deterioration state indicating deterioration occurring during the first time period, while considering: time dependence varying depending on the cause of deterioration and following a power law with respect to an elapsed time of the cause-based deterioration state; and a deterioration rate varying depending on the cause of deterioration and determined based on a use condition at time of prediction.

A characteristic configuration of a deterioration-state prediction apparatus according to one embodiment of the present invention lies in a deterioration-state prediction apparatus configured to predict a deterioration state of a secondary battery, the apparatus including: a previous cause-based deterioration state acquisition unit configured to acquire, for each cause of deterioration of the secondary battery, a previous cause-based deterioration state being a cause-based deterioration state acquired a first time period ago for the cause of deterioration; a use condition acquisition unit configured to acquire a use condition at time of prediction at which the deterioration state of the secondary battery is predicted; a deterioration rate coefficient calculation unit configured to determine, for each cause of deterioration, a deterioration rate coefficient corresponding to a deterioration rate of the secondary battery with use of the use condition; a cause-based deterioration state computation unit configured to calculate the cause-based deterioration state for each cause of deterioration based on: a time coefficient applied to an elapsed time predetermined for the cause of deterioration; the deterioration rate coefficient; and the previous cause-based deterioration state; and a deterioration-state computation unit configured to predict the deterioration state of the secondary battery based on a plurality of the cause-based deterioration states calculated for corresponding causes of deterioration.

A characteristic configuration of a deterioration-state prediction program according to one embodiment of the present invention lies in a deterioration-state prediction program configured to predict a deterioration state of a secondary battery, the program causing a computer to execute: a function of acquiring, for each cause of deterioration of the secondary battery, a previous cause-based deterioration state being a cause-based deterioration state obtained a first time period ago for the cause of deterioration; a function of acquiring a use condition at time of prediction at which the deterioration state of the secondary battery is predicted; a function of determining, for each cause of deterioration, a deterioration rate coefficient corresponding to a deterioration rate of the secondary battery with use of the use condition; a function of calculating the cause-based deterioration state for each cause of deterioration based on: a time coefficient applied to an elapsed time predetermined for the cause of deterioration; the deterioration rate coefficient; and the previous cause-based deterioration state; and a function of predicting the deterioration state of the secondary battery based on a plurality of the cause-based deterioration states calculated for corresponding causes of deterioration.

Deterioration of a secondary battery progresses while being affected by a plurality of causes of deterioration. The progress rate of deterioration (deterioration state) varies between causes of deterioration. Furthermore, the progress rate of the cause-based deterioration state complexly changes depending on the use conditions. It is difficult to comprehensively calculate the deterioration state of the secondary battery while considering a plurality of causes of deterioration, whereas it is relatively easy to individually calculate the cause-based deterioration state for each cause of deterioration. The deterioration state of the secondary battery can be easily and accurately predicted by individually calculating the cause-based deterioration state for each cause of deterioration and predicting the deterioration state of the secondary battery based on the cause-based deterioration state.

As a result of intensive study, the inventors have discovered that the cause-based deterioration state for each cause of deterioration has time dependence that follows a power law and depends on the deterioration rate that varies depending on the cause of deterioration. That is, the inventors have discovered that the cause-based deterioration state for each cause of deterioration can be calculated based on the deterioration rate and the time dependence.

Here, the deterioration rate changes from time to time depending on various use conditions, such as temperature conditions, charging and discharging current, and a battery voltage, even with the same cause of deterioration. The deterioration rate is therefore not constant from when the secondary battery begins to be used to the time point at which the deterioration state is predicted, and it is difficult to accurately calculate the deterioration state (cause-based deterioration state) if a fixed deterioration rate is used for each cause of deterioration.

The cause-based deterioration state is calculated based on the previous cause-based deterioration state, which is the deterioration state (cause-based deterioration state) up to a certain, immediately previous time point, and the unit cause-based deterioration state, which is the deterioration state (cause-based deterioration state) during a time period from that time point until the first time period elapses from the time point. This allows only the deterioration rate during the first time period to be considered and can thus suppress the influence of changes in the use conditions on the deterioration rate. As a result, the deterioration state of the secondary battery can be accurately predicted.

The deterioration state (cause-based deterioration state) is obtained while considering the deterioration rate calculated in accordance with the use conditions at the time of prediction (present time point) rather than using a constant deterioration rate for each cause of deterioration. This enables accurate prediction of the deterioration state of the secondary battery.

The cause-based deterioration state may be obtained as

$$\mu_t = \{\mu_{(t-\delta)}{}^{1/\beta} \cdot \alpha^{1/\beta} \cdot \delta\}^{\beta},$$

where t denotes a time of prediction, $\delta$ denotes the first time period, $\mu_t$ denotes the cause-based deterioration state, $\mu_{(t-\delta)}$ denotes the previous cause-based deterioration state, $\alpha$ denotes a deterioration rate coefficient corresponding to the deterioration rate, and $\beta$ denotes a time coefficient indicating the time dependence.

This configuration enables easy and accurate prediction of the deterioration state of the secondary battery.

The deterioration state may be obtained by adding up all of the calculated cause-based deterioration states.

This configuration enables the deterioration state to be predicted while easily and appropriately considering a plurality of cause-based deterioration states, and enables easy and accurate prediction of the deterioration state of the secondary battery.

The previous cause-based deterioration state may be an actual measurement value obtained by any method.

This configuration makes it possible to predict the cause-based deterioration state during a time period from when the secondary battery begins to be used until the time of prediction by substantially only predicting the cause-based deterioration state during the first time period with use of the actual previous cause-based deterioration state. This configuration enables accurate prediction of the deterioration state of the secondary battery.

The previous cause-based deterioration state may be the cause-based deterioration state calculated based on: the previous cause-based deterioration state at a time point a second time period before a time point before the first time period; and the unit cause-based deterioration state during the second time period.

This configuration makes it possible to predict the cause-based deterioration state during a time period from when the secondary battery begins to be used until the time of prediction by repeating the prediction of the cause-based deterioration state during a short time period during which the change in the use conditions can be expected to be limited. This configuration enables accurate prediction of the deterioration state of the secondary battery.

The deterioration rate may be determined with use of temperature information, current information, and voltage information as the use condition, the temperature information may include at least one of: cell temperature; environmental temperature; and air temperature, the current information may include at least one of: a charging current; a discharging current; a charging rate; a discharging rate; a total amount of discharged electricity; and a total amount of charged electricity, and the voltage information may include at least one of: an average voltage; an average charging state; an upper-limit charging voltage; a lower-limit discharging voltage; a time spent in a range of a predetermined charging state; and an overvoltage.

This configuration makes it possible to select appropriate use conditions in response to the cause of deterioration and determine the deterioration rate with use of the selected use conditions. As a result, the deterioration state of the secondary battery can be accurately predicted.

The overvoltage may be obtained by applying a current to the secondary battery over a predetermined time period and stopping the current, and subtracting a voltage value of the secondary battery at a time point before starting applying the current to the secondary battery from a voltage value of the secondary battery at a time point a predetermined third time period after the start of applying the current.

This configuration makes it possible to obtain an overvoltage easily and accurately. The deterioration rate can thus be accurately determined. As a result, the deterioration state of the secondary battery can be accurately predicted.

The overvoltage may be obtained by applying a current to the secondary battery over a predetermined time period and stopping the current, and subtracting a voltage value of the secondary battery at a time point a predetermined fourth time period after the stop of the current from a voltage value of the secondary battery while the current is applied.

This configuration makes it possible to obtain an overvoltage easily and accurately. The deterioration rate can thus be accurately determined. As a result, the deterioration state of the secondary battery can be accurately predicted.

The overvoltage may be obtained as a product of the charging current and an internal resistance of the secondary battery.

This configuration makes it possible to obtain an overvoltage easily and accurately. The deterioration rate can thus be accurately determined. As a result, the deterioration state of the secondary battery can be accurately predicted.

The deterioration rate may be determined with use of: use history data including history of the temperature information, history of the current information, and history of the voltage information; and cell status history data including at least one of: battery capacity history; resistance history, battery voltage history; output history; outer dimensions; and a confining pressure.

This configuration makes it possible to more accurately determine the deterioration rate and accurately predict the deterioration state of the secondary battery.

The deterioration rate may be determined by machine-learning the use history data and the cell status history data.

This configuration makes it possible to more accurately determine the deterioration rate and accurately predict the deterioration state of the secondary battery.

Brief Description of the Drawings

FIG. 1 is a diagram showing an example of a functional configuration of a deterioration-state prediction apparatus.
FIG. 2 is a diagram showing an example of a flow of deterioration-state prediction.
FIG. 3 illustrates a comparison between actual measurement values and deterioration-state prediction performed while considering one cause of deterioration.
FIG. 4 illustrates a comparison between actual measurement values and deterioration-state prediction performed while considering two causes of deterioration.
FIG. 5 illustrates a comparison between actual measurement values and deterioration-state prediction performed with use of a deterioration rate coefficient determined based on one use condition.
FIG. 6 illustrates a comparison between actual measurement values and deterioration-state prediction performed with use of a deterioration rate coefficient determined based on three use conditions.

Best Mode for Carrying out the Invention

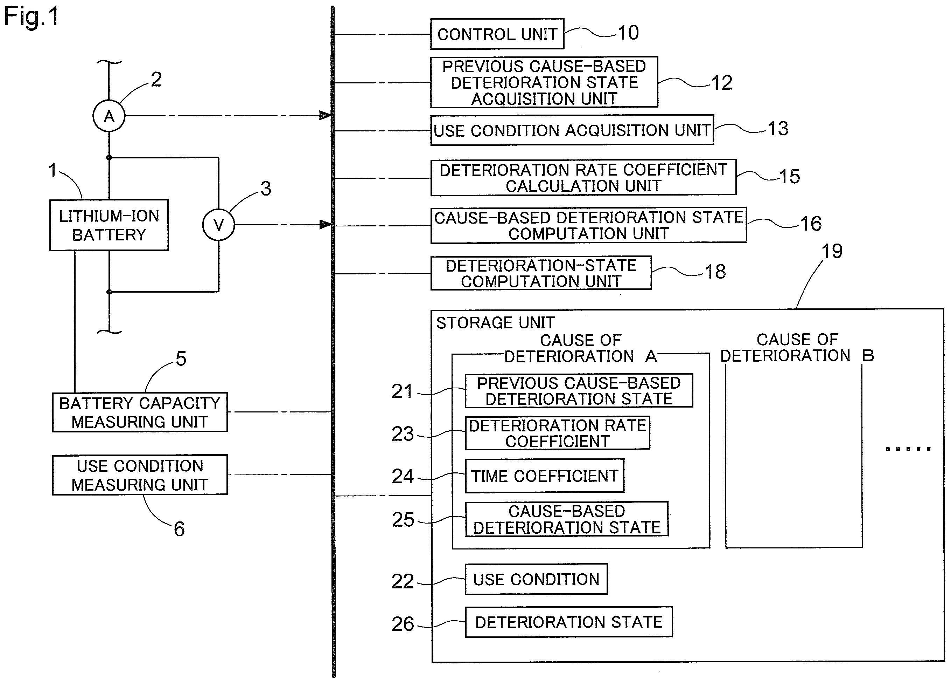

Deterioration of a secondary battery is caused by various reaction mechanisms (causes of deterioration), such as an increase of a resistance film at an electrode-electrolyte interface (SEI), metal Li (electrode metal) precipitation on an electrode surface, cracks in an electrode active material, crystal phase transition, and a gas generation caused by electrolyte decomposition. In prediction of a deterioration state 26 (see FIG. 1) of a secondary battery, the deterioration state 26 (cause-based deterioration state 25) is obtained for each cause of deterioration, and the deterioration state 26 of the secondary battery is obtained based on one or more cause-based deterioration states 25. Note that the deterioration state 26 is, for example, indicated by a value that decreases from 1, which indicates the chargeable capacity of an unused secondary battery, as deterioration progresses, and is also referred to as a "state of health" (SOH).

Deterioration of the secondary battery can be approximated by a power law with respect to the time (elapsed time) from when the secondary battery begins to be used. That is, deterioration of the secondary battery has time dependence proportional to a power law of time and depends on the deterioration rate. This proportional relationship can be expressed by using a later-described deterioration rate coefficient 23 (see FIG. 1) as a constant and a later-described time coefficient 24 (see FIG. 1) as an exponent.

Here, the deterioration rate coefficient 23 depends on various use conditions 22 (see FIG. 1), such as a use environment, a use method, and a use mode. Further, the use conditions 22 often change during the use of the secondary battery. If the deterioration state 26 (cause-based deterioration state 25) of the secondary battery over a long time period (during the lapse of a long time) is calculated (predicted) with use of a constant deterioration rate coefficient 23, an error may occur in response to variations in the use conditions 22, making it difficult to accurately predict the deterioration state 26 (cause-based deterioration state 25) of the secondary battery.

The cause-based deterioration state 25 of the secondary battery is therefore calculated based on a previous cause-based deterioration state 21 (see FIG. 1) that is obtained in advance and a unit cause-based deterioration state during a time period from when the previous cause-based deterioration state 21 was calculated (measured) until a first time period, which may be any time period, elapses.

The previous cause-based deterioration state 21 is the deterioration state 26 (cause-based deterioration state 25) of the secondary battery at a time point the first time period before the present time point (time point at which the deterioration state 26 of the secondary battery is predicted). The previous cause-based deterioration state 21 may alternatively be a prediction value (cause-based deterioration state 25) calculated the first time period before the present time point. In this case, at a time point the first time period before the present time point, the cause-based deterioration state 25 calculated at a time point a second time period before that time point is acquired as the previous cause-based deterioration state 21, and the cause-based deterioration state 25 is calculated. The above calculation of the cause-based deterioration state 25 is repeated. The previous cause-based deterioration state 21 may alternatively be an actual measurement value measured with a predetermined means the first time period before the present time point. The previous cause-based deterioration state 21 may alternatively be a corrected prediction value obtained by correcting a prediction value (cause-based deterioration state 25) calculated the first time period before the present time point while additionally considering an actual measurement value measured with a predetermined method the first time period before the present time point.

The unit cause-based deterioration state is the deterioration state 26 (cause-based deterioration state 25) of the secondary battery during a time period from when the previous cause-based deterioration state 21 was calculated/measured (acquired) to the present time point, i.e. during the first time period. Note that if, at a time point the first time period before the present time point, the cause-based deterioration state 25 calculated at a time point the second time period before that time point is used as the previous cause-based deterioration state 21, the unit cause-based deterioration state is the deterioration state 26 (cause-based deterioration state 25) of the secondary battery during a time period from the time point at which the previous cause-based deterioration state 21 was calculated/measured (acquired) until the time point the first time period before the present time point is reached, i.e. during the second time period.

The deterioration state 26 (cause-based deterioration state 25) at the present time point (at the time of prediction) has a proportional relationship with the time coefficient 24 as an exponent, and the deterioration state 26 (cause-based deterioration state 25) is therefore calculated based on the previous cause-based deterioration state 21 and the unit cause-based deterioration state while considering the time dependence that follows the power law with respect to the elapsed time. That is, the deterioration state 26 (cause-based deterioration state 25) is calculated based on the previous cause-based deterioration state 21 and the unit cause-based deterioration state regarding deterioration during the first time period, while considering the time dependence that varies depending on the cause of deterioration and follows the power law with respect to the elapsed time of the cause-based deterioration state 25, and the deterioration rate varying depending on the cause of deterioration and determined by the use conditions 22 at the time of prediction. For example, the deterioration state 26 (cause-based deterioration state 25) at the present time point (at the time of prediction) is calculated with Equation 1, which will be described later.

The deterioration state 26 can be calculated with use of the cause-based deterioration state 25 calculated for each cause of deterioration by calculating the deterioration state 26 of the secondary battery as described above, thus enabling accurate calculation of the deterioration state 26 of the secondary battery.

Further, the time period for calculating the deterioration state 26 (unit cause-based deterioration state) can be shortened by calculating the cause-based deterioration state 25 with use of the unit cause-based deterioration state during the first time period, thereby suppressing the influence of variations in the use conditions 22. As a result, the deterioration rate coefficient 23 is accurately determined, and the unit cause-based deterioration state (cause-based deterioration state 25) can be accurately calculated.

The deterioration state 26 (cause-based deterioration state 25) can be predicted with use of the previous cause-based deterioration state 21, thus reducing the portion that requires calculation (prediction) and enabling more accurate calculation of the deterioration state 26 (cause-based deterioration state 25) of the secondary battery. In particular, if the previous cause-based deterioration state 21 is an actual measurement value or a corrected prediction value that has been corrected while additionally considering the actual measurement value, the portion that requires actual prediction is reduced to a portion for only the first time period, and the deterioration state 26 (cause-based deterioration state 25) of the secondary battery can be calculated more accurately. Note that even if the previous cause-based deterioration state 21 is a calculated value, the use conditions 22 can be determined with respect to a short time period, and it is only necessary to calculate the deterioration state 26 (cause-based deterioration state 25) for each short time period, thus enabling accurate calculation of the deterioration state 26 (cause-based deterioration state 25) of the secondary battery.

Deterioration-state prediction

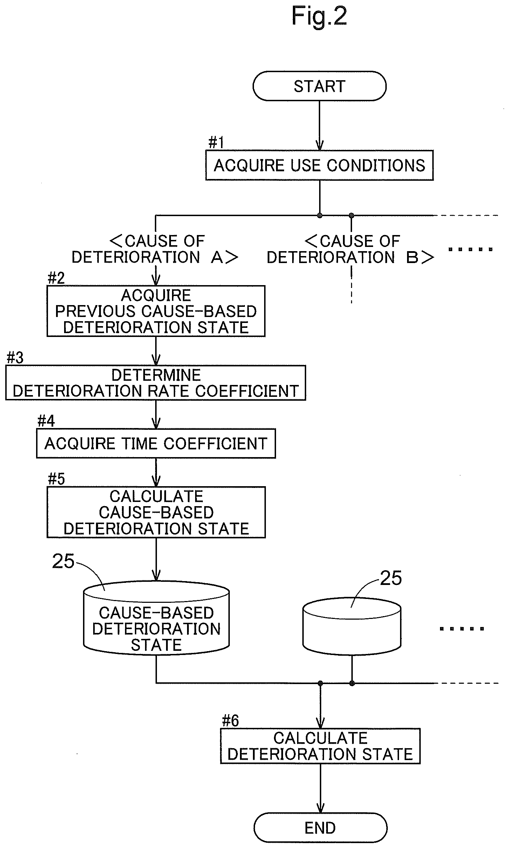

A functional configuration of the deterioration-state prediction apparatus that predicts the deterioration state 26 of the secondary battery, and a deterioration-state prediction method are described with reference to FIGS. 1 and 2. The following description takes an example of a configuration for predicting the deterioration state 26 of the lithium-ion battery 1 serving as an example of the secondary battery.

The lithium-ion battery 1 can be charged and discharged, and supplies electric power to various devices, which are power-consuming objects, by discharging electric power stored by charging. An ammeter 2 is connected in series to the lithium-ion battery 1. The ammeter 2 measures a current value at the lithium-ion battery 1. A voltmeter 3 is also connected in parallel to the lithium-ion battery 1. The voltmeter 3 measures a voltage value across the lithium-ion battery 1.

A battery capacity measuring unit 5 is connected to the lithium-ion battery 1 and measures the battery capacity for electric power storable in the lithium-ion battery 1. A use condition measuring unit 6 is provided around the lithium-ion battery 1. The use condition measuring unit 6 measures various use conditions 22 of the lithium-ion battery 1, such as use environment including temperature (cell temperature), environmental temperature, and air temperature, and a method/mode of use.

The deterioration-state prediction apparatus that predicts the deterioration state 26 of the lithium-ion battery 1 includes a control unit 10, a previous cause-based deterioration state acquisition unit12, a use condition acquisition unit 13, a deterioration rate coefficient calculation unit 15, a cause-based deterioration state computation unit 16, a deterioration-state computation unit 18, and a storage unit 19.

The control unit 10 includes a processor such as a CPU and controls operation of each functional unit of the deterioration-state prediction apparatus.

The use condition acquisition unit 13 acquires various use conditions 22 of the lithium-ion battery 1, such as use environment and a method/mode of use that are acquired by the ammeter 2, the voltmeter 3, the use condition measuring unit 6, or any other method (step #1 in FIG. 2). The use conditions 22 to be acquired are those at the present time point (when the deterioration state 26 is predicted (at the time of prediction)), i.e. at a time point the first time period has elapsed since the previous cause-based deterioration state 21 (cause-based deterioration state 25) acquired by the later-described previous cause-based deterioration state acquisition unit 12 was calculated and acquired. The use condition acquisition unit 13 stores the acquired use conditions 22 in the storage unit 19.

The previous cause-based deterioration state acquisition unit12 acquires, for each cause of deterioration, the cause-based deterioration state 25 the first time period, which may be any time period, before the present time point (time of prediction) as the previous cause-based deterioration state 21 (step #2 in FIG. 2). The previous cause-based deterioration state 21 is the deterioration state 26 (cause-based deterioration state 25) of the lithium-ion battery 1 that has deteriorated by the time the first time period before the time of prediction. If, for example, the deterioration state 26 of the lithium-ion battery 1 is predicted at predetermined or any time intervals, the previous cause-based deterioration state acquisition unit12 acquires, for each cause of deterioration, the cause-based deterioration state 25 that was calculated immediately previously or in the past. Alternatively, the previous cause-based deterioration state acquisition unit12 acquires, for each cause of deterioration, the cause-based deterioration state 25 that was acquired the first time period, which may be any time period, before the present time point with use of any means. The previous cause-based deterioration state acquisition unit 12 stores the acquired previous cause-based deterioration state 21 in association with the cause of deterioration in the storage unit 19.

The deterioration rate coefficient calculation unit 15 determines the deterioration rate coefficient 23 for each cause of deterioration based on the use conditions 22 acquired by the use condition acquisition unit 13 (step #3 in FIG. 2). As mentioned above, the deterioration state 26 (cause-based deterioration state 25) is proportional to the power law of time. The deterioration rate coefficient 23 is a coefficient corresponding to the deterioration rate and corresponds to a constant of this proportional relationship (proportional expression).

The use conditions 22 to be used to determine the deterioration rate coefficient 23 can be optionally set in correspondence with the causes of deterioration. For example, the use conditions 22 may include temperature information, current information, and voltage information.

These use conditions 22 are measured by the ammeter 2, the voltmeter 3, the use condition measuring unit 6, or the like, and are obtained by further performing calculation as necessary.

The temperature information includes at least one of: cell temperature, which is the temperature of the lithium-ion battery 1; environmental temperature, which is the temperature around the lithium-ion battery 1; and air temperature, and any of these temperatures is selected in response to the cause of deterioration. The current information includes at least one of the following types of information regarding charging and discharging the lithium-ion battery 1: a charging current, a discharging current, a charging rate (Crate), a discharging rate (Orate), a total amount of discharged electricity, and a total amount of charged electricity, and any of these types of information is selected in response to the cause of deterioration. The voltage information includes at least one of the following types of information regarding the lithium-ion battery 1: an average voltage, an average charging state, an upper-limit charging voltage, a lower-limit discharging voltage, a time spent in a range of a predetermined charging state, and overvoltage, and any of these types of information is selected in response to the cause of deterioration.

Deterioration of the lithium-ion battery 1 is affected by the state of use of the lithium-ion battery 1; e.g. how often the lithium-ion battery 1 is used; whether charging and discharging are successively repeated; and whether there is a time period when the use is stopped. It is thus particularly preferable that the use conditions 22 include a total amount of discharged electricity, a total amount of charged electricity, a time spent in a range of a predetermined state of charge, or the like.

The deterioration rate coefficient 23 can be determined by any method with use of the selected use conditions 22, but may also be calculated with use of a calculation method predetermined for each cause of deterioration.

For example, the deterioration rate coefficient 23 can be obtained by substituting the acquired use conditions 22 into a predetermined calculation formula for the deterioration rate coefficient 23. The calculation formula for the deterioration rate coefficient 23 can be obtained by collecting in advance a plurality of selected use conditions 22 and battery deterioration data of the lithium-ion battery 1, and performing regression analysis on the collected data. Note that the regression analysis model may be any of the Arrhenius equation (Arrhenius model: physicochemical empirical formula expressing the temperature dependence of reaction rate) or Butler-Volmer equation (theoretical formula expressing the relationship between the reaction rate, overvoltage, and temperature) as a physicochemical model, as well as any of the linear model (linear multiple regression model), the generalized linear model, Gaussian process regression, random forest regression, a neural network, support vector regression, or the like as a statistical model (machine learning model). For example, the linear multiple regression model and the Arrhenius model can be used in combination.

Here, the time coefficient 24 for each cause of deterioration used to calculate the cause-based deterioration state 25 is obtained in advance and stored in the storage unit 19. The stored time coefficient 24 is acquired for each cause of deterioration (step #4 in FIG. 2). As mentioned above, the deterioration state 26 is proportional to the power law of time. The time coefficient 24 is a coefficient indicating the time dependence of the deterioration state 26 and corresponds to an exponent. Similar to the deterioration rate coefficient 23, the time coefficient 24 can be calculated through regression analysis with use of a statistical model (machine learning model). The time coefficient 24 may be calculated by any of the functional blocks of the deterioration-state prediction apparatus, namely the control unit 10, the deterioration rate coefficient calculation unit 15, or the cause-based deterioration state computation unit 16, but may alternatively be calculated by a unit other than the functional blocks of the deterioration-state prediction apparatus.

The cause-based deterioration state computation unit 16 calculates the cause-based deterioration state 25 for each cause of deterioration based on the previous cause-based deterioration state 21, the deterioration rate coefficient 23, and the time coefficient 24 (step #5 in FIG. 2). The cause-based deterioration state computation unit 16 stores the calculated cause-based deterioration state 25 in association with the cause of deterioration in the storage unit 19. The cause-based deterioration state computation unit 16 may calculate the cause-based deterioration state 25 with use of any method, while as mentioned above, the cause-based deterioration state 25 is calculated with use of the proportional relationship to time with the deterioration rate coefficient 23 as a constant and the time coefficient 24 as an exponent, while considering the previous cause-based deterioration state 21. That is, the cause-based deterioration state computation unit 16 calculates the cause-based deterioration state 25 based on the previous cause-based deterioration state 21 and the deterioration state 26 (unit cause-based deterioration state) of the lithium-ion battery 1 during the elapsed time (first time period) after acquiring the previous cause-based deterioration state 21.

For example, the cause-based deterioration state computation unit 16 calculates the cause-based deterioration state 25 at the time of prediction with use of a function indicated by the following Equation 1:

$$\mu_t = \{\mu_{(t-\delta)}^{1/\beta} - \alpha^{1/\beta} \cdot \delta\}^\beta \ ... \ \text{Equation 1,}$$

where t denotes the time of prediction, $\delta$ denotes the first time period, $\mu_t$ denotes the cause-based deterioration state 25 at the time t, $\mu_{(t-\delta)}$ denotes the previous cause-based deterioration state 21, $\alpha$ denotes the deterioration rate coefficient 23, and ß denotes the time coefficient 24.

The deterioration-state computation unit 18 calculates the deterioration state 26 of the lithium-ion battery 1 at the time of prediction based on the cause-based deterioration state 25 stored for each cause of deterioration in the storage unit 19 (step #6 in FIG. 2). For example, the deterioration-state computation unit 18 adds up all of the calculated cause-based deterioration states 25 to calculate a prediction value of the deterioration state 26 of the lithium-ion battery 1.

The deterioration state 26 calculated based on the above Equation 1 is calculated as the following Equations 2:

$$SOH_t = f(\mu_{1t}, \mu_{2t}, \mu_{3t}, ...)$$

$$\mu_{1t} = \{\mu_{1(t-\delta)}^{1/\beta 1} - \alpha_1^{1/\beta 1} \cdot \delta\}^{\beta 1}$$

$$\mu_{2t} = \{\mu_{2(t-\delta)}^{1/\beta 2} - \alpha_2^{1/\beta 2} \cdot \delta\}^{\beta 2}$$

$$\mu_{3t} = \{\mu_{3(t-\delta)}^{1/\beta 3} - \alpha_3^{1/\beta 3} \cdot \delta\}^{\beta 3} \ ... \ \text{Equation 2,}$$

where $SOH_t$ denotes the deterioration state 26 at the time t, $\delta$ denotes the first time period, $\mu_{nt}$ denotes each cause-based deterioration state 25 at the time t, $\mu_{n(t-\delta)}$ denotes the previous cause-based deterioration state 21 for each cause-based deterioration state 25, $\alpha_n$ denotes the deterioration rate coefficient 23 for each cause-based deterioration state 25, and $\beta_n$ denotes the time coefficient 24 for each cause-based deterioration state 25 (n = 1, 2, 3 ...)

By predicting the deterioration state 26 of the lithium-ion battery 1 with use of the deterioration-state prediction apparatus having the above configuration, the deterioration rate coefficient 23 is determined for each cause of deterioration with use of one or more appropriate use conditions 22 selected in response to the cause of deterioration, thus facilitating determination of an appropriate deterioration rate coefficient 23. As a result, the deterioration state 26 of the lithium-ion battery 1 at the present time point (time of prediction) can be predicted accurately.

There are various causes of deterioration of the lithium-ion battery 1, and the state of progress of deterioration is also diverse. For example, in the deterioration of the lithium-ion battery 1 due to the growth of a film on the negative electrode surface of the lithium-ion battery 1 (SEI film growth), the deterioration rapidly progresses at the initial stage of use of the lithium-ion battery 1, but then slows down after the reaction has progressed to a certain extent. In the deterioration of the lithium-ion battery 1 due to, for example, gas generation at the positive electrode, cracks in the positive electrode active material, and precipitation of metal Li in the negative electrode, the deterioration hardly progresses at the initial stage of use of the lithium-ion battery 1, but the deterioration rate tends to increase after the deterioration has progressed.

In response to such a variety of causes of deterioration, the deterioration-state prediction apparatus according to the present embodiment obtains more appropriate deterioration rate coefficient 23 and time coefficient 24 in accordance with the use conditions 22. That is, the deterioration-state prediction apparatus determines the method for calculating the deterioration rate coefficient 23 and the time coefficient 24 for each cause of deterioration that reflects deterioration caused by the SEI film growth, Li precipitation, gas generation, or the like, based on data acquired in advance with use of a lithium-ion battery 1 serving as an actual sample. The deterioration state 26 (cause-based deterioration state 25) of the lithium-ion battery 1 can be accurately predicted with use of a model based on the thus-obtained deterioration rate coefficient 23 and time coefficient 24.

The deterioration rate coefficient 23 for each cause of deterioration is affected by the use conditions 22, which change from time to time while the lithium-ion battery 1 is in use. It has been difficult to accurately calculate the deterioration state 26 (cause-based deterioration state 25) of the lithium-ion battery 1 if the deterioration rate coefficient 23 is a fixed value for each cause of deterioration. According to this embodiment, the previous cause-based deterioration state 21 for each cause of deterioration at a time point before the present time point (time of prediction) is acquired, and the cause-based deterioration state 25 can be obtained with use of a model based on the previous cause-based deterioration state 21 and the amount of change in the cause-based deterioration state (unit cause-based deterioration state) during the time period from the time of calculation or measurement of the previous cause-based deterioration state 21 until the time of prediction. As a result, the influence of changes in the use conditions 22 can be suppressed, thus enabling accurate prediction of the deterioration state 26 of the lithium-ion battery 1 at the present time point (time of prediction).

Comparative Results

Next, experimental results of predicting the deterioration state of the lithium-ion battery 1 (secondary battery) according to the present embodiment are described with reference to FIGS. 1 and 3 to 6.

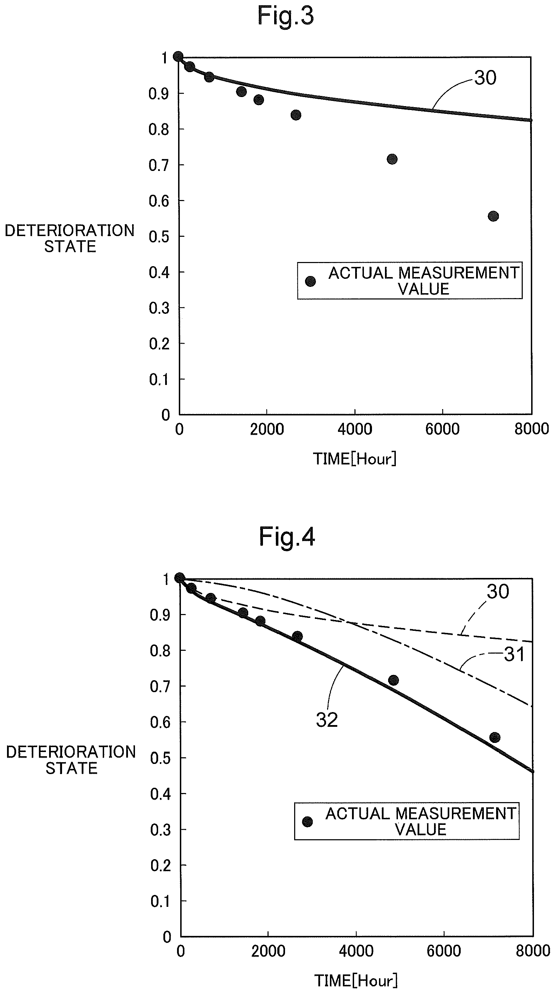

First, FIG. 3 shows experimental results in the case of predicting the deterioration state while considering only Li consumption due to SEI film growth as a cause of deterioration, i.e. considering only one cause of deterioration. Note that a line 30 in FIG. 3 indicates the results of predicting the deterioration state while considering only Li consumption due to SEI film growth as a cause of deterioration, with the first time period being $\delta = 240$ hours, the deterioration rate coefficient 23 being $\alpha = 0.002$, and the time coefficient 24 being $\beta = 0.5$ in the above Equation 1. FIG. 4 shows experimental results of predicting the deterioration state while considering Li consumption due to SEI film growth and high-temperature deterioration (deterioration due to gas generation) as causes of deterioration, with the first time period being $\delta = 240$ hours, the deterioration rate coefficient 23 for Li consumption being $\alpha1 = 0.002$, the time coefficient 24 for Li consumption being $\beta1 = 0.5$, the deterioration rate coefficient 23 for high-temperature deterioration being $\alpha2 = 0.5 \times 10^{-6}$, and the time coefficient 24 for high-temperature deterioration being $\beta2 = 1.5$ in the above Equation 2. In FIG. 4, a line 30 indicates the results of predicting the deterioration state while considering only Li consumption due to SEI film growth as a cause of deterioration. A line 31 indicates the results of predicting the deterioration state while considering only high-temperature deterioration as a cause of deterioration. A line 32 indicates the results of predicting the deterioration state while considering Li consumption due to SEI film growth and high-temperature deterioration as causes of deterioration.

It can be understood that the prediction results indicated by the lines 30 and 31 obtained by predicting the deterioration state while considering only one cause of deterioration do not match actual measurement values obtained from the experiment, as shown in FIGS. 3 and 4. In contrast, the line 32 obtained by predicting the deterioration state while considering more than one cause of deterioration substantially matches the actual measurement values obtained from the experiment, as shown in FIG. 4.

It can be understood from the above results that the deterioration state 26 can be accurately predicted by calculating the cause-based deterioration state 25 for each of a plurality of causes of deterioration and calculating the deterioration state 26 of the secondary battery based on the plurality of cause-based deterioration states 25.

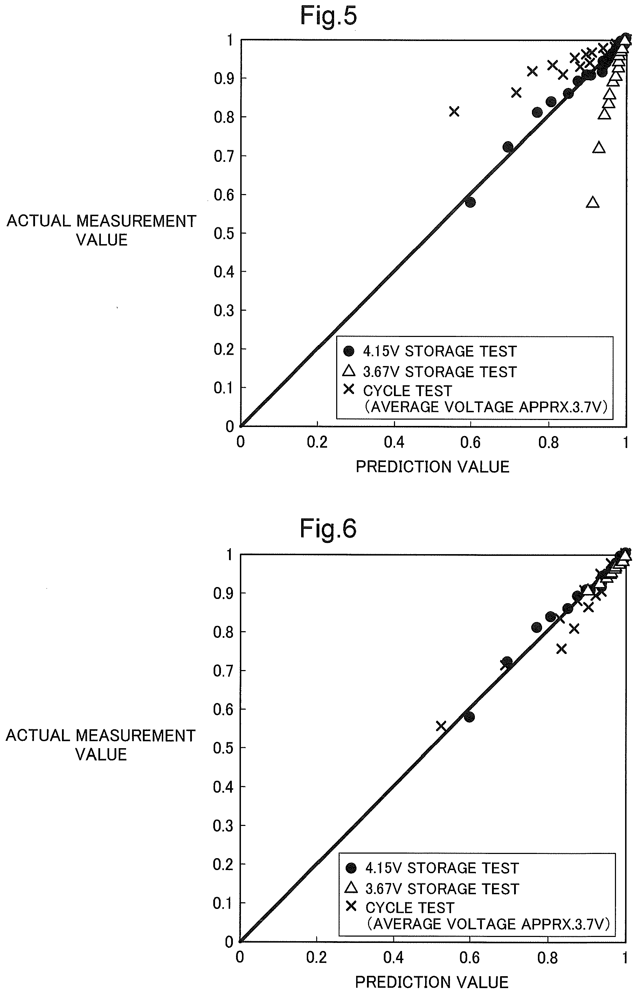

FIG. 5 shows the relationship between the prediction results and the actual measurement values in the case of determining the deterioration rate coefficient 23 for Li consumption and the deterioration rate coefficient 23 for high-temperature deterioration as follows while considering Li consumption due to SEI film growth and high-temperature deterioration (deterioration due to gas generation) as causes of deterioration and considering only the temperature (cell temperature) as a use condition 22, and predicting the deterioration state 26 for each cause of deterioration with the first time period being $\delta = 240$ hours, the time coefficient 24 for Li consumption being $\beta1 = 0.5$, the time coefficient 24 for high-temperature deterioration being $\beta2 = 1.5$ in the above Equation 2. FIG. 6 shows the relationship between the prediction results and the actual measurement values in the case of determining the deterioration rate coefficient 23 for Li consumption and the deterioration rate coefficient 23 for high-temperature deterioration, as in FIG. 5, while considering the temperature (cell temperature), the average voltage, and the charging rate as use conditions 22, and predicting the deterioration state 26 for each cause of deterioration with the first time period being $\delta = 240$ hours, the time coefficient 24 for Li consumption being $\beta1 = 0.5$, the time coefficient 24 for high-temperature deterioration being $\beta2 = 1.5$ in the above Equation 2.

Note that the deterioration rate coefficient 23 used in the prediction shown in FIG. 5 and determined while considering only the cell temperature can be obtained by the following Equation 3:

$$\alpha = \alpha_0 \times \exp\left(Ea / RT\right) \text{ ... Equation 3,}$$

where $\alpha$ denotes the deterioration rate coefficient 23, $\alpha_0$ denotes a predetermined reference coefficient, Ea denotes a constant independent of the cell temperature, R denotes a gas constant (approx. 8.314), and T denotes the cell temperature (absolute temperature [K]).

The deterioration rate coefficient 23 used in the prediction shown in FIG. 6 and determined while considering the cell temperature, the average voltage, and the charging rate can be obtained by the following Equation 4:

$$\alpha = (WV \times V + r) \times \exp(Ea / RT) + WC \times C \text{ ... Equation 4,}$$

where $\alpha$ denotes the deterioration rate coefficient 23, WV denotes a predetermined reference voltage, V denotes the average voltage at the time of prediction, WC denotes a predetermined reference charging rate, C denotes the charging rate during charging performed at the time of prediction or immediately before the prediction, r denotes a predetermined constant, Ea denotes a constant independent of the cell temperature, R denotes a gas constant (approx. 8.314), and T denotes the cell temperature (absolute temperature [K]).

Note that the deterioration rate coefficient 23 in this case can also be obtained by the following Equation 5.

$$\alpha = (WV \times V + WC \times C + r) \times \exp(Ea / RT) \dots \text{Equation 5}$$

Here, the experiment was conducted with different use conditions 22 (use environments), and the relationship between the prediction results and actual measurement values was illustrated for the case of fixing (storing) the voltage of the lithium-ion battery 1 (secondary battery) at 4.15 V (4.15-V storage test), the case of fixing (storing) the voltage at 3.67 V (3.67-V storage test), and the case of repeating a predetermined cycle of charging and discharging at a charging rate of 0.7 C (cycle test) such that the average voltage is 3.7 V In the figures, the closer the relationship between the prediction results and the actual measurement values is to a proportional relationship with a slope of 1 (solid line in the figures), the more the prediction results and the actual measurement values coincide with each other.

The prediction results and the actual measurement values substantially coincide with each other in the case of fixing (storing) the voltage at 4.15 V (4.15-V storage test) as shown in FIG. 5. However, the prediction results and the actual measurement values do not coincide with each other in the case of fixing (storing) the voltage at 3.67 V (3.67-V storage test) and in the case of repeating a predetermined cycle of charging and discharging at a charging rate of 0.7 C (cycle test) such that the average voltage is 3.7 V These results indicate that if the deterioration rate coefficient 23 is determined without using appropriate use conditions 22 (use environments), there are cases where the cause of deterioration and the deterioration rate coefficient 23 do not match and the deterioration state 26 cannot be accurately predicted.

In contrast, the prediction results and the actual measurement values substantially coincide with each other in all cases when the deterioration rate coefficient 23 is determined while considering the temperature, the average voltage, and the charging rate as the use conditions 22 and the deterioration state 26 is predicted with use of the thus-determined deterioration rate coefficient 23, as shown in FIG. 6.

It can be understood from the above experiment results that the deterioration rate coefficient 23 that matches the cause of deterioration can be accurately determined by determining the deterioration rate coefficient 23 with use of a plurality of use conditions 22 in accordance with the cause of deterioration, thus enabling accurate prediction of the deterioration state 26.

Other Embodiments

(1) The secondary battery whose deterioration state 26 is to be predicted in the above embodiment is not limited to the lithium-ion battery 1, but may be any type of secondary battery capable of various types of charging and discharging, such as a non-aqueous secondary battery.

(2) In the above embodiments, the overvoltage, which is one of the use conditions 22 for determining the deterioration rate coefficient 23, can be obtained by various methods as follows.

For example, the overvoltage can be obtained by applying a current to the secondary battery (lithium-ion battery 1) over a predetermined time period and stopping the current, and subtracting a voltage value of the secondary battery at a time point before starting applying the current to the secondary battery from a voltage value of the secondary battery at a time point a predetermined third time period after the start of applying the current. The third time period may be, for example, 0.5 seconds or more and 60 seconds or less. The overvoltage caused due to the charging/discharging reaction on the electrode surface can be accurately obtained by thus setting the third time period, and the deterioration rate coefficient 23 can be accurately calculated.

The overvoltage may also be obtained by applying a current to the secondary battery (lithium-ion battery 1) over a predetermined time period and stopping the current, and subtracting a voltage value of the secondary battery at a time point a predetermined fourth time period after the stop of the current from a voltage value of the secondary battery while the current is applied. The fourth time period may be, for example, 0.5 seconds or more and 60 seconds or less. The overvoltage can be accurately obtained by thus setting the fourth time period, and the deterioration rate coefficient 23 can be accurately calculated.

The overvoltage can also be obtained as the product of the charging current and the internal resistance of the secondary battery.

(3) The deterioration rate coefficient 23 may be determined with use of use history data including temperature information history (past trends), current information history, and voltage information history, as well as cell status history data including at least one of the battery capacity history, resistance history, battery voltage history, output history, outer dimensions, and confining pressure.

For example, the deterioration rate coefficient 23 can be determined by machine-learning the use history data and the cell status history data.

The deterioration rate coefficient 23 can thus be more accurately determined while considering the history of the use conditions 22. As a result, the deterioration state 26 (cause-based deterioration state 25) of the secondary battery (lithium-ion battery 1) can be predicted accurately.

(4) In the above embodiments, the deterioration-state prediction apparatus is not limited to including functional blocks such as those shown in FIG. 1, and may include any functional blocks. For example, each functional block of the deterioration-state prediction apparatus may be further subdivided, or conversely, some or all of the functional blocks may be combined. The aforementioned deterioration-state prediction method is not limited to being performed by the deterioration-state prediction apparatus shown in FIG. 1, and may be performed by deterioration-state prediction apparatuses having any configuration. Some or all of the functions of the deterioration-state prediction apparatus may be configured by software. A program associated with the software is stored in any storage device such as the storage unit 19, and is executed by a processor (computer) such as a CPU included in the control unit 10 or a separately provided processor (computer).

Note that the configurations disclosed in the above embodiments (including other embodiments; the same applies hereinafter) can be applied in combination with configurations disclosed in other embodiments as long as no contradiction arises. The embodiments disclosed herein are examples, and the embodiments of the present invention are not limited thereto and can be modified as appropriate without departing from the object of the present invention.

Industrial Applicability

The present invention can be applied to prediction of the deterioration state of various secondary batteries such as lithium-ion batteries.

Description of Reference Signs

1       Lithium-ion battery (secondary battery)
12      Previous cause-based deterioration state acquisition unit
13      Use condition acquisition unit
15      Deterioration rate coefficient calculation unit
16      Cause-based deterioration state computation unit
18      Deterioration-state computation unit
19      Storage unit
21      Previous cause-based deterioration state
22      Use condition
23      Deterioration rate coefficient
24      Time coefficient
25      Cause-based deterioration state
26      Deterioration state

**Claims**

1.  A deterioration-state prediction method for calculating a cause-based deterioration state for each cause of deterioration and predicting a deterioration state of a secondary battery based on a plurality of the cause-based deterioration states, the method comprising:
    calculating each of the cause-based deterioration states based on: a previous cause-based deterioration state being the cause-based deterioration state a first time period ago; and a unit cause-based deterioration state indicating deterioration occurring during the first time period, while considering: time dependence varying depending on the cause of deterioration and following a power law with respect to an elapsed time of the cause-based deterioration state; and a deterioration rate varying depending on the cause of deterioration and determined based on a use condition at time of prediction.

2.  The deterioration-state prediction method according to claim 1,

    wherein the cause-based deterioration state is obtained as

$$\mu_t = \{\mu_{(t-\delta)}{}^{1/\beta} \cdot \alpha^{1/\beta} \cdot \delta\}^\beta,$$

where t denotes a time of prediction, $\delta$ denotes the first time period, $\mu_t$ denotes the cause-based deterioration state, $\mu_{(t-\delta)}$ denotes the previous cause-based deterioration state, $\alpha$ denotes a deterioration rate coefficient corresponding to the deterioration rate, and ß denotes a time coefficient indicating the time dependence.

3. The deterioration-state prediction method according to claim 2,
wherein the deterioration state is obtained by adding up all of the calculated cause-based deterioration states.

4. The deterioration-state prediction method according to any one of claims 1 to 3,
wherein the previous cause-based deterioration state is an actual measurement value obtained by any method.

5. The deterioration-state prediction method according to any one of claims 1 to 3,
wherein the previous cause-based deterioration state is the cause-based deterioration state calculated based on: the previous cause-based deterioration state at a time point a second time period before a time point before the first time period; and the unit cause-based deterioration state during the second time period.

6. The deterioration-state prediction method according to any one of claims 1 to 3,

wherein the deterioration rate is determined with use of temperature information, current information, and voltage information as the use condition,
the temperature information includes at least one of: cell temperature; environmental temperature; and air temperature,
the current information includes at least one of: a charging current; a discharging current; a charging rate; a discharging rate; a total amount of discharged electricity; and a total amount of charged electricity, and
the voltage information includes at least one of: an average voltage; an average charging state; an upper-limit charging voltage; a lower-limit discharging voltage; a time spent in a range of a predetermined charging state; and an overvoltage.

7. The deterioration-state prediction method according to claim 6,
wherein the overvoltage is obtained by applying a current to the secondary battery over a predetermined time period and stopping the current, and subtracting a voltage value of the secondary battery at a time point before starting applying the current to the secondary battery from a voltage value of the secondary battery at a time point a predetermined third time period after the start of applying the current.

8. The deterioration-state prediction method according to claim 6,
wherein the overvoltage is obtained by applying a current to the secondary battery over a predetermined time period and stopping the current, and subtracting a voltage value of the secondary battery at a time point a predetermined fourth time period after the stop of the current from a voltage value of the secondary battery while the current is applied.

9. The deterioration-state prediction method according to claim 6,
wherein the overvoltage is obtained as a product of the charging current and an internal resistance of the secondary battery.

10. The deterioration-state prediction method according to claim 6,
wherein the deterioration rate is determined with use of:

use history data including history of the temperature information, history of the current information, and history of the voltage information; and
cell status history data including at least one of: battery capacity history; resistance history, battery voltage history; output history; outer dimensions; and a confining pressure.

11. The deterioration-state prediction method according to claim 10,
wherein the deterioration rate is determined by machine-learning the use history data and the cell status history data.

12. A deterioration-state prediction apparatus configured to predict a deterioration state of a secondary battery, the apparatus comprising:

a previous cause-based deterioration state acquisition unit configured to acquire, for each cause of deterioration of the secondary battery, a previous cause-based deterioration state being a cause-based deterioration state acquired a first time period ago for the cause of deterioration;

a use condition acquisition unit configured to acquire a use condition at time of prediction at which the deterioration state of the secondary battery is predicted;

a deterioration rate coefficient calculation unit configured to determine, for each cause of deterioration, a deterioration rate coefficient corresponding to a deterioration rate of the secondary battery with use of the use condition;

a cause-based deterioration state computation unit configured to calculate the cause-based deterioration state for each cause of deterioration based on: a time coefficient applied to an elapsed time predetermined for the cause of deterioration; the deterioration rate coefficient; and the previous cause-based deterioration state; and

a deterioration-state computation unit configured to predict the deterioration state of the secondary battery based on a plurality of the cause-based deterioration states calculated for corresponding causes of deterioration.

13. A deterioration-state prediction program configured to predict a deterioration state of a secondary battery, the program causing a computer to execute:

a function of acquiring, for each cause of deterioration of the secondary battery, a previous cause-based deterioration state being a cause-based deterioration state obtained a first time period ago for the cause of deterioration;

a function of acquiring a use condition at time of prediction at which the deterioration state of the secondary battery is predicted;

a function of determining, for each cause of deterioration, a deterioration rate coefficient corresponding to a deterioration rate of the secondary battery with use of the use condition;

a function of calculating the cause-based deterioration state for each cause of deterioration based on: a time coefficient applied to an elapsed time predetermined for the cause of deterioration; the deterioration rate coefficient; and the previous cause-based deterioration state; and

a function of predicting the deterioration state of the secondary battery based on a plurality of the cause-based deterioration states calculated for corresponding causes of deterioration.

Fig.1

# Fig.2

START

#1 ACQUIRE USE CONDITIONS

<CAUSE OF DETERIORATION A>     <CAUSE OF DETERIORATION B> ......

#2 ACQUIRE PREVIOUS CAUSE-BASED DETERIORATION STATE

#3 DETERMINE DETERIORATION RATE COEFFICIENT

#4 ACQUIRE TIME COEFFICIENT

#5 CALCULATE CAUSE-BASED DETERIORATION STATE

25 — CAUSE-BASED DETERIORATION STATE

25 ......

#6 CALCULATE DETERIORATION STATE

END

## Fig.3

## Fig.4

## Fig.5

ACTUAL MEASUREMENT VALUE

PREDICTION VALUE

● 4.15V STORAGE TEST
△ 3.67V STORAGE TEST
✕ CYCLE TEST
(AVERAGE VOLTAGE APPRX.3.7V)

## Fig.6

ACTUAL MEASUREMENT VALUE

PREDICTION VALUE

● 4.15V STORAGE TEST
△ 3.67V STORAGE TEST
✕ CYCLE TEST
(AVERAGE VOLTAGE APPRX.3.7V)

| | INTERNATIONAL SEARCH REPORT | International application No. |
|---|---|---|
| | | **PCT/JP2023/008593** |

**A. CLASSIFICATION OF SUBJECT MATTER**

*G01R 31/392*(2019.01)i; *H01M 10/42*(2006.01)i; *H01M 10/48*(2006.01)i
FI: G01R31/392; H01M10/42 P; H01M10/48 P; H01M10/48 301

According to International Patent Classification (IPC) or to both national classification and IPC

**B. FIELDS SEARCHED**

Minimum documentation searched (classification system followed by classification symbols)

G01R31/36; H01M10/48; G01R31/00; H02J7/00

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | JP 2013-210340 A (PANASONIC CORP.) 10 October 2013 (2013-10-10)<br>entire text, all drawings | 1-13 |
| A | JP 2011-220900 A (HONDA MOTOR CO., LTD.) 04 November 2011 (2011-11-04)<br>entire text, all drawings | 1-13 |
| A | JP 2014-52186 A (HONDA MOTOR CO., LTD.) 20 March 2014 (2014-03-20)<br>entire text, all drawings | 1-13 |
| A | JP 2020-3497 A (GS YUASA INTERNATIONAL LTD.) 09 January 2020 (2020-01-09)<br>entire text, all drawings | 1-13 |
| A | JP 2019-53074 A (GS YUASA INTERNATIONAL LTD.) 04 April 2019 (2019-04-04)<br>entire text, all drawings | 1-13 |
| A | WO 2017/002292 A1 (SONY CORP.) 05 January 2017 (2017-01-05)<br>entire text, all drawings | 1-13 |
| A | WO 2018/117105 A1 (GS YUASA INTERNATIONAL LTD.) 28 June 2018 (2018-06-28)<br>entire text, all drawings | 1-13 |

☑ Further documents are listed in the continuation of Box C.  ☑ See patent family annex.

| | |
|---|---|
| * Special categories of cited documents:<br>"A" document defining the general state of the art which is not considered to be of particular relevance<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
|---|---|
| **25 April 2023** | **16 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

| | International application No. |
|---|---|
| | **PCT/JP2023/008593** |

### C. DOCUMENTS CONSIDERED TO BE RELEVANT

| Category* | Citation of document, with indication, where appropriate, of the relevant passages | Relevant to claim No. |
|---|---|---|
| P, A | WO 2023/022224 A1 (ELIIY POWER CO., LTD.) 23 February 2023 (2023-02-23)<br>entire text, all drawings | 1-13 |
| P, A | WO 2023/022225 A1 (ELIIY POWER CO., LTD.) 23 February 2023 (2023-02-23)<br>entire text, all drawings | 1-13 |

Form PCT/ISA/210 (second sheet) (January 2015)

**INTERNATIONAL SEARCH REPORT**
Information on patent family members

International application No.

**PCT/JP2023/008593**

| Patent document cited in search report | | | Publication date (day/month/year) | Patent family member(s) | | | Publication date (day/month/year) |
|---|---|---|---|---|---|---|---|
| JP | 2013-210340 | A | 10 October 2013 | (Family: none) | | | |
| JP | 2011-220900 | A | 04 November 2011 | (Family: none) | | | |
| JP | 2014-52186 | A | 20 March 2014 | (Family: none) | | | |
| JP | 2020-3497 | A | 09 January 2020 | US | 2019/0317155 | A1 | |
| | | | | entire text, all drawings | | | |
| | | | | WO | 2018/117105 | A1 | |
| | | | | EP | 3561531 | A1 | |
| | | | | CN | 110100185 | A | |
| | | | | KR | 10-2019-0088498 | A | |
| JP | 2019-53074 | A | 04 April 2019 | US | 2020/0057113 | A1 | |
| | | | | entire text, all drawings | | | |
| | | | | WO | 2018/181609 | A1 | |
| | | | | EP | 3605124 | A1 | |
| | | | | CN | 110476072 | A | |
| WO | 2017/002292 | A1 | 05 January 2017 | US | 2018/0115024 | A1 | |
| | | | | entire text, all drawings | | | |
| | | | | EP | 3319203 | A1 | |
| | | | | CA | 2982426 | A1 | |
| | | | | CN | 107636870 | A | |
| WO | 2018/117105 | A1 | 28 June 2018 | US | 2019/0317155 | A1 | |
| | | | | entire text, all drawings | | | |
| | | | | EP | 3561531 | A1 | |
| | | | | CN | 110100185 | A | |
| | | | | KR | 10-2019-0088498 | A | |
| WO | 2023/022224 | A1 | 23 February 2023 | (Family: none) | | | |
| WO | 2023/022225 | A1 | 23 February 2023 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2019171688 A